# EUROPEAN PATENT APPLICATION

(11) **EP 4 391 046 A1**
(43) Date of publication of application: **26.06.2024**
(21) Application number: 22932597.2
(22) Date of filing: 22.03.2022
(51) Int. Cl.: H01L 23/498

(54) **SEMICONDUCTOR DEVICE, ELECTRONIC APPARATUS, AND METHOD FOR MANUFACTURING SEMICONDUCTOR DEVICE**

(71) Applicant: Huawei Digital Power Technologies Co., Ltd., Shenzhen, Guangdong 518043 (CN)
(72) Inventor: HOENE, Eckart, 80686 Munich (DE); PAWLAK, Luise, 80686 Munich (DE); WU, Ming, Shenzhen, Guangdong 518129 (CN); XU, Xiaofeng, Shenzhen, Guangdong 518129 (CN); HE, Zhengyan, Shenzhen, Guangdong 518129 (CN)
(74) Representative: Gill Jennings & Every LLP
(86) International application number: PCT/CN2022/082346
(87) International publication number: WO 2023/178528

(57) **Abstract**

This application provides a semiconductor device, including a package body, a chip, a redistribution layer, and a conductive hot melt layer, where the chip, the redistribution layer, and the conductive hot melt layer are all packaged in the package body. The redistribution layer includes a first conductive pad and a second conductive pad that are disposed at intervals and insulated, where a part of the redistribution layer other than the first conductive pad and the second conductive pad is connected to a pin of the chip; and the conductive hot melt layer is formed on a surface of the first conductive pad and a surface of the second conductive pad, and is in electrical contact with both the first conductive pad and the second conductive pad. This application further provides an electronic apparatus including the semiconductor device and a semiconductor device manufacturing method. According to solutions of this application, overcurrent protection of the semiconductor device can be implemented, so that the semiconductor device does not bum the printed circuit board even if overcurrent occurs.

## Description

### TECHNICAL FIELD

This application relates to the semiconductor manufacturing field, and in particular, to a semiconductor device, an electronic apparatus, and a semiconductor device manufacturing method.

### BACKGROUND

A power semiconductor device is welded on a printed circuit board to maintain power supply to the board. However, once overcurrent occurs on the power semiconductor device, a chip may be burnt, generated heat may bum the printed circuit board, and the printed circuit board cannot be repaired. Therefore, how to avoid damage of the printed circuit board caused by the overcurrent of the power semiconductor device is an urgent problem to be resolved.

### SUMMARY

This application provides a semiconductor device, an electronic apparatus, and a semiconductor device manufacturing method, so as to implement overcurrent protection of the semiconductor device, so that a printed circuit board is not burnt even if overcurrent occurs on the semiconductor device.

According to a first aspect, this application provides a semiconductor device, including a package body, a chip, a redistribution layer, and a conductive hot melt layer, where the chip, the redistribution layer, and the conductive hot melt layer are all packaged in the package body. The redistribution layer includes a first conductive pad and a second conductive pad that are disposed at intervals and insulated, where a part of the redistribution layer other than the first conductive pad and the second conductive pad is connected to a pin of the chip; and the conductive hot melt layer is formed on a surface of the first conductive pad and a surface of the second conductive pad, and is in electrical contact with both the first conductive pad and the second conductive pad.

In solutions of this application, the package body is manufactured by using a package material, and is configured to package the chip, the redistribution layer, and the conductive hot melt layer. The "chip" may refer to a die (die) or a packaged chip. The redistribution layer is electrically connected to the chip, and is configured to electrically connect the chip to each part in the package body, so as to implement fan-out of the chip. Both the first conductive pad and the second conductive pad are a part of the redistribution layer, and both the first conductive pad and the second conductive pad are formed in a manufacturing process of the redistribution layer. Both the first conductive pad and the second conductive pad have a specific spacing with the chip. The conductive hot melt layer has conductive and heat melting performance. The conductive hot melt layer is connected to the first conductive pad and the second conductive pad, and the conductive hot melt layer participates in forming an electrical connection path of the semiconductor device.

In solutions of this application, the first conductive pad and the second conductive pad may alternatively belong to another layer that is in the semiconductor device and that is electrically connected to the chip. In other words, both the first conductive pad and the second conductive pad may be formed in a manufacturing process of the layer.

In solutions of this application, when the semiconductor device is overheated due to overcurrent, the package body cracks and forms a gap. An insulation layer on the first conductive pad and the second conductive pad may also crack to form a gap. When the semiconductor device is overheated, the conductive hot melt layer can be melted by heat conducted by the chip in the semiconductor device. Due to a capillary effect of the gap, the conductive hot melt layer in a melt state is broken between the first conductive pad and the second conductive pad, and flows into the gap. In this way, the electrical connection between the first conductive pad and the second conductive pad is disconnected, so that the semiconductor device enters an open-circuit state. Therefore, the semiconductor device stops heating. This avoids burning the circuit board.

In an implementation of the first aspect, the semiconductor device includes an insulation layer, and the insulation layer is located between the first conductive pad and the second conductive pad. The insulation layer has insulation performance, and can well isolate the first conductive pad from the second conductive pad.

In an implementation of the first aspect, the insulation layer and the conductive hot melt layer jointly cover the surface of the first conductive pad, and/or the insulation layer and the conductive hot melt layer jointly cover the surface of the second conductive pad. In this solution, a part of the insulation layer and the conductive hot melt layer may be distributed on a same surface of the first conductive pad. In this way, the insulation layer can limit a pattern shape of the conductive hot melt layer. This helps the conductive hot melt layer be formed based on a design requirement. Similarly, a part of the insulation layer and the conductive hot melt layer may be distributed on a same surface of the second conductive pad. In this way, the insulation layer can limit a pattern shape of the conductive hot melt layer. This helps the conductive hot melt layer be formed based on a design requirement.

In an implementation of the first aspect, the insulation layer has hydrophobic performance. When liquid is in contact with a surface of the insulation layer, the liquid is not likely to infiltrate the insulation layer. To be specific, the liquid cannot be stably attached to the surface of the insulation layer, and is not likely to permeate through the insulation layer. This insulation layer helps make the conductive hot melt layer in the melt state on the insulation layer enter the gap. Therefore, the hydrophobic performance of the insulation layer causes the conductive hot melt layer to fuse at the insulation layer.

In an implementation of the first aspect, a material of the insulation layer includes a solder resist material. The solder resist material has good insulation performance and hydrophobic performance, and can ensure that the insulation layer reliably performs an insulation function, or insulation and hydrophobic functions.

In an implementation of the first aspect, the package body includes a first package body and a second package body, where the first package body and the second package body are combined to jointly package the chip, the redistribution layer, and the conductive hot melt layer, the chip is packaged in the first package body, the pin is exposed outside the first package body, and both the redistribution layer and the conductive hot melt layer are packaged in the second package body. In this solution, materials of the first package body and the second package body may be the same or different. For example, the first package body and the second package body may be combined in a laminated manner (which may be manufactured by using a press-fitting process). The semiconductor device in this solution may be packaged by using an embedded component, so as to resolve a problem that a circuit board is burnt due to overheating of an embedded component packaging structure.

In an implementation of the first aspect, the semiconductor device includes a substrate, a redistribution layer is formed on the substrate, the first conductive pad and the second conductive pad are isolated by a local area of the substrate, the chip is disposed on the substrate, and the package body covers the substrate. In this solution, a structure including a substrate and a redistribution layer may also be referred to as a substrate, and the substrate has a conductive line inside. The semiconductor device in this solution may use plastic packaging (molding), which can resolve a problem that the circuit board is burnt due to overheating of a plastic packaging structure.

In an implementation of the first aspect, a material of the conductive hot melt layer includes solder. The solder has good conductivity, welding performance, and ideal hot melt performance. This can ensure that the conductive hot melt layer reliably performs an electrical connection and a fuse function.

In an implementation of the first aspect, the semiconductor device includes a power semiconductor device. The power semiconductor device is configured to perform power processing, such as frequency conversion, voltage conversion, current conversion, and power management. Heating of the power semiconductor device is obvious, and an overcurrent protection design of this solution can well solve the problem of burning the circuit board.

According to a second aspect, this application provides an electronic apparatus, including a circuit board and the semiconductor device, where the semiconductor device is disposed on the circuit board. In this solution, the electronic apparatus may be an electronic component such as a module or a module group, or may be an integrated device with several electronic components. Because the semiconductor device in the electronic apparatus in this solution has an overcurrent protection design, the circuit board can be prevented from being burnt, and therefore security and reliability are high.

In an implementation of the second aspect, the electronic apparatus includes at least one of: a motor controller, a vehicle-mounted charger, a power supply, an inverter, an electric vehicle, a data center, a photovoltaic power generation device, and a server. Because the semiconductor device in the electronic apparatus in this solution has the overcurrent protection design, the circuit board can be prevented from being burnt, and therefore security and reliability are high.

According to a third aspect, this application provides a semiconductor device manufacturing method, including: forming a redistribution layer, where the redistribution layer includes a first conductive pad and a second conductive pad that are disposed at intervals and insulated; forming a conductive hot melt layer on the first conductive pad and the second conductive pad, where the conductive hot melt layer is in electrical contact with both the first conductive pad and the second conductive pad; connecting a pin of a chip to a part of the redistribution layer other than the first conductive pad and the second conductive pad; and packaging the chip, the redistribution layer, and the conductive hot melt layer.

In this solution, the foregoing semiconductor device can be manufactured. In this solution, an overcurrent protection structure is implanted in a chip packaging process, so that the overcurrent protection structure can be manufactured by using a mature chip packaging process, so that design and manufacturing of the semiconductor device are convenient, costs are low, and mass production is good.

In an implementation of the third aspect, the "forming a redistribution layer, where the redistribution layer includes a first conductive pad and a second conductive pad that are disposed at intervals and insulated" includes: packaging the chip by using a first packaging material, where the pin is exposed; forming the redistribution layer on the first packaging material, where the redistribution layer includes the first conductive pad and the second conductive pad that are disposed at intervals; and forming an insulation layer between the first conductive pad and the second conductive pad, where the insulation layer isolates the first conductive pad from the second conductive pad; and the "packaging the chip, the redistribution layer, and the conductive hot melt layer" includes: packaging the redistribution layer, the insulation layer, and the conductive hot melt layer by using a second packaging material, where the second packaging material and the first packaging material are combined to jointly package the chip, the redistribution layer, the insulation layer, and the conductive hot melt layer.

In this solution, a semiconductor device packaged by using an embedded component can be manufactured. In this solution, the first packaging material may form a first package body, and the second packaging material may form a second package body. In this solution, the first conductive pad and the second conductive pad that are disposed at intervals and insulated can be manufactured by using a manufacturing process of the redistribution layer, and the conductive hot melt layer is formed on the first conductive pad and the second conductive pad, so that an overcurrent protection structure can be manufactured by using a mature chip packaging process, so that design and manufacturing of the semiconductor device are convenient, costs are low, and mass production is good.

In an implementation of the third aspect, the "forming a redistribution layer, where the redistribution layer includes a first conductive pad and a second conductive pad that are disposed at intervals and insulated" includes: forming the redistribution layer on a substrate, where the redistribution layer includes the first conductive pad and the second conductive pad that are disposed at intervals, and the first conductive pad and the second conductive pad are isolated by a local area of the substrate; and the "packaging the chip, the redistribution layer, and the conductive hot melt layer by using a packaging material" includes: forming a package body on the substrate, where the package body packages the chip, the redistribution layer, and the conductive hot melt layer.

In this solution, a semiconductor device that uses molding packaging can be manufactured. In this solution, the first conductive pad and the second conductive pad that are disposed at intervals and insulated can be formed by using a substrate manufacturing process, and the conductive hot melt layer is formed on the first conductive pad and the second conductive pad, so that an overcurrent protection structure can be manufactured by using a mature chip packaging process, so that design and manufacturing of the semiconductor device are convenient, costs are low, and mass production is good.

### BRIEF DESCRIPTION OF DRAWINGS

FIG. 1 is a schematic diagram of a top view structure of an overcurrent protection structure in a semiconductor device according to an embodiment of this application;
FIG. 2 is a schematic diagram of a side view structure of an overcurrent protection structure in a semiconductor device according to an embodiment of this application;
FIG. 3 is a schematic diagram of a top view structure that is after a conductive hot melt layer in the semiconductor device in FIG. 1 is heated and fused;
FIG. 4 is a schematic diagram of a side view structure that is after a conductive hot melt layer in the semiconductor device in FIG. 2 is heated and fused;
FIG. 5 is a schematic diagram of a side view structure of a semiconductor device according to Embodiment 1 of this application;
FIG. 6 is a schematic diagram of a side view structure of a manufacturing process of the semiconductor device in FIG. 5;
FIG. 7 is a schematic diagram of a side view structure of another manufacturing process of the semiconductor device in FIG. 5;
FIG. 8 is a schematic diagram of a side view structure of another manufacturing process of the semiconductor device in FIG. 5;
FIG. 9 is a schematic diagram of a side view structure of another manufacturing process of the semiconductor device in FIG. 5;
FIG. 10 is a schematic diagram of a side view structure of a semiconductor device according to Embodiment 3 of this application;
FIG. 11 is a schematic diagram of a side view structure of a manufacturing process of the semiconductor device in FIG. 10;
FIG. 12 is a schematic diagram of a side view structure of another manufacturing process of the semiconductor device in FIG. 10; and
FIG. 13 is a schematic diagram of a side view structure of another manufacturing process of the semiconductor device in FIG. 10.

### DESCRIPTION OF EMBODIMENTS

Embodiments of this application provide an electronic apparatus. The electronic apparatus may include a circuit board and a semiconductor device disposed on the circuit board.

In embodiments of this application, the electronic apparatus may be an electronic component such as a module or a module group, or may be an integrated device with several electronic components. An application field of the electronic apparatus may be determined based on a requirement. This is not limited in embodiments of this application.

For example, the electronic apparatus may be applied to the field of wireless power amplifiers and electric vehicle power systems. The electronic apparatus in this field may be a motor controller, a vehicle-mounted controller (on-board charger, OBC), a low-voltage control power supply, or the like, or the electronic apparatus may be an electric vehicle including at least one of: a motor controller, a vehicle-mounted controller, a low-voltage control power supply, or the like.

Alternatively, the electronic apparatus may be applied to other fields, such as conventional industrial control, communications, wireless power amplification, a smart grid, and an electrical appliance. The electronic device in this field may be, for example, an uninterruptible power supply (uninterruptible power supply, UPS) of a data center, an inverter of a photovoltaic power generation device, a power supply of a server, or a switching power supply of an electric appliance (for example, a refrigerator), where the uninterruptible power supply, the power supply of the server, and the switching power supply of the electric appliance may be collectively referred to as a power supply. Alternatively, the electronic apparatus in this field may be a data center, a server, an electrical appliance, or the like that includes a power supply, or may be a photovoltaic power generation device that includes an inverter, or the like.

In embodiments of this application, a type and a function of the semiconductor device may be determined based on an actual requirement. This is not limited in embodiments of this application. For example, the semiconductor device may be a power semiconductor device, and is configured to perform power processing, such as frequency conversion, voltage conversion, current conversion, and power management. For example, the electronic apparatus including the semiconductor device may be an electric energy conversion apparatus.

### Overcurrent protection principle of the semiconductor device

In solutions of embodiments of this application, an overcurrent protection structure is implanted in a component package through a packaging process of a semiconductor device. The overcurrent protection structure includes a conductive hot melt layer, and the conductive hot melt layer is used as a part of an electrical connection path of the semiconductor device. When the semiconductor device is overheated (heat generation is excessive and a temperature exceeds a threshold) due to overcurrent (a current is excessively high), the conductive hot melt layer can be fused and therefore an open circuit occurs on the semiconductor device, so that the semiconductor device stops heating. This avoids burning of a printed circuit board due to the overcurrent of the semiconductor device.

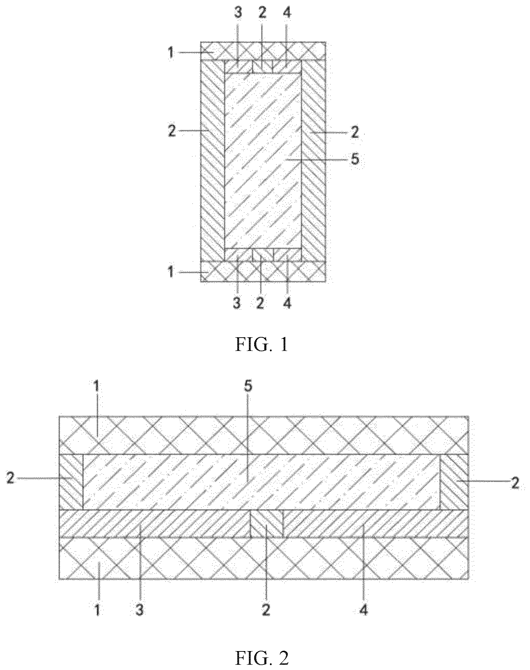

The following describes the overcurrent protection structure with reference to FIG. 1 to FIG. 4. It may be understood that, to focus on describing a structure and a working principle of the overcurrent protection structure, FIG. 1 to FIG. 4 do not show other structures such as a chip in the semiconductor device.

FIG. 1 and FIG. 2 respectively show the overcurrent protection structure from different views. With reference to FIG. 1 and FIG. 2, the overcurrent protection structure may include a package body 1, an insulation layer 2, a first conductive pad 3, a second conductive pad 4, and a conductive hot melt layer 5.

As shown in FIG. 1 and FIG. 2, the package body 1 packages the insulation layer 2, the first conductive pad 3, the second conductive pad 4, and the conductive hot melt layer 5. The package body 1 may be made of a polymer package material, and the polymer package material may be one or more types of materials.

As shown in FIG. 1 and FIG. 2, there is a gap between the first conductive pad 3 and the second conductive pad 4. The gap may be small. For example, the gap may be between 0.1 mm and 5 mm. Both the first conductive pad 3 and the second conductive pad 4 may be made of a conductive material, for example, copper. It may be understood that the first conductive pad 3 and the second conductive pad 4 are not limited to being disposed side by side on a horizontal plane as shown in FIG. 2 provided that there is a spacing between the first conductive pad 3 and the second conductive pad 4. For example, the first conductive pad 3 and the second conductive pad 4 may be alternatively disposed at intervals in a stacked manner in a vertical direction in FIG. 2.

In this embodiment of this application, both the first conductive pad 3 and the second conductive pad 4 may be a part of a redistribution layer (redistribution layer, RDL) in the semiconductor device. In other words, the first conductive pad 3 and the second conductive pad 4 are manufactured in a packaging process of forming the redistribution layer (which is further described below). The redistribution layer is electrically connected to a chip in the semiconductor device, and is configured to electrically connect the chip to each part in a package structure, so as to implement fan-out packaging of the chip. Based on a requirement, there may be at least one redistribution layer, and the first conductive pad 3 and the second conductive pad 4 may belong to one of the at least one redistribution layer. For brevity, only one redistribution layer is drawn in the accompanying drawings of embodiments of this application. This is merely an example, and is not a limitation on embodiments of this application.

FIG. 1 and FIG. 2 show two conductive pads: the first conductive pad 3 and the second conductive pad 4. This is merely an example. Actually, there are two or more conductive pads in embodiments of this application.

As shown in FIG. 1 and FIG. 2, the insulation layer 2 is provided between the first conductive pad 3 and the second conductive pad 4, and the insulation layer 2 isolates the first conductive pad 3 from the second conductive pad 4. The insulation layer 2 has electrical insulation performance, and can electrically isolate the first conductive pad 3 from the second conductive pad 4.

In an embodiment, the insulation layer 2 may further have hydrophobic performance. When liquid is in contact with a surface of the insulation layer 2, the liquid is not likely to infiltrate the insulation layer 2. To be specific, the liquid cannot be stably attached to the surface of the insulation layer 2, and is not likely to permeate through the insulation layer 2. A contact angle of the liquid on the surface of the insulation layer 2 may be greater than 90°, so that the insulation layer 2 has the hydrophobic performance. In another embodiment, the insulation layer 2 may not need to have the hydrophobic performance.

For example, the insulation layer 2 may be made of a solder resist material, for example, solder resist ink.

In this embodiment of this application, when there are more than two conductive pads, there may be an insulation layer 2 between every two adjacent conductive pads, and the insulation layer 2 electrically isolates the two conductive pads.

In addition, at least one of a surface of the first conductive pad 3 and a surface of the second conductive pad 4 may also have an insulation layer 2. For example, in the view of FIG. 2, there is an insulation layer 2 above and to the left of the first conductive pad 3, and there is an insulation layer 2 above and to the right of the second conductive pad 4. The insulation layers 2 here are used to limit a pattern of the conductive hot melt layer 5. In another embodiment, at least one of the surface of the first conductive pad 3 and the surface of the second conductive pad 4 may have no insulation layer 2, and the insulation layer 2 is formed only between the first conductive pad 3 and the second conductive pad 4.

In another embodiment, the first conductive pad 3 and the second conductive pad 4 may be isolated and insulated in another manner, and the insulation layer 2 may be formed between the first conductive pad 3 and the second conductive pad 4 without a manufacturing process.

As shown in FIG. 1 and FIG. 2, the conductive hot melt layer 5 is formed on surfaces of the first conductive pad 3, the insulation layer 2, and the second conductive pad 4, and is in electrical contact with both the first conductive pad 3 and the second conductive pad 4. The conductive hot melt layer 5 only needs to be connected to the first conductive pad 3 and the second conductive pad 4. A pattern shape of the conductive hot melt layer 5 may be designed based on a requirement, and is not limited to that a left boundary of the conductive hot melt layer 5 shown in FIG. 2 is indented within a left boundary of the first conductive pad 3 (that is, a left end of the first conductive pad 3 exceeds a left end of the conductive hot melt layer 5), and a right boundary of the conductive hot melt layer 5 is indented within a left boundary of the second conductive pad 4 (that is, a right end of the second conductive pad 4 exceeds a right end of the conductive hot melt layer 5). For example, the left end of the conductive hot melt layer 5 may be basically flush with the left end of the first conductive pad 3 (there may be no insulation layer 2 at the left end of the first conductive pad 3), and the right end of the conductive hot melt layer 5 may also be basically flush with the right end of the second conductive pad 4 (there may be no insulation layer 2 at the right end of the second conductive pad 4). In this embodiment of this application, when the quantity of conductive pads is greater than two, the conductive hot melt layer 5 may be formed on every two adjacent conductive pads and the insulation layer 2 between the two conductive pads, and the conductive hot melt layer 5 electrically connects the two conductive pads. In other words, all conductive pads may be conductive by using the conductive hot melt layer 5. The conductive hot melt layer 5 has conductive performance. Therefore, the conductive hot melt layer 5 can enable the first conductive pad 3 and the second conductive pad 4 to be conductive, so that the semiconductor device can be powered on and work.

A resistance of the conductive hot melt layer 5 is small, and therefore, the conductive hot melt layer 5 generates small heat when being powered on. The conductive hot melt layer 5 can become a melt state when a temperature exceeds a specific temperature threshold. The temperature threshold may be determined based on an actual heating status of the semiconductor device, for example, approximately 300 degrees Celsius.

A specific material of the conductive hot melt layer 5 may be determined based on a requirement, for example, may be solder, and specifically, may be tin, or solder alloys such as gold indium alloy, tin bismuth alloy, tin indium alloy, tin lead alloy, tin zinc alloy, tin silver copper alloy, tin silver alloy, tin copper alloy, tin silver copper bismuth alloy, tin silver copper antimony alloy, tin silver copper indium alloy, tin antimony alloy, lead tin silver alloy, gold tin alloy, gold germanium alloy, and gold silicon alloy.

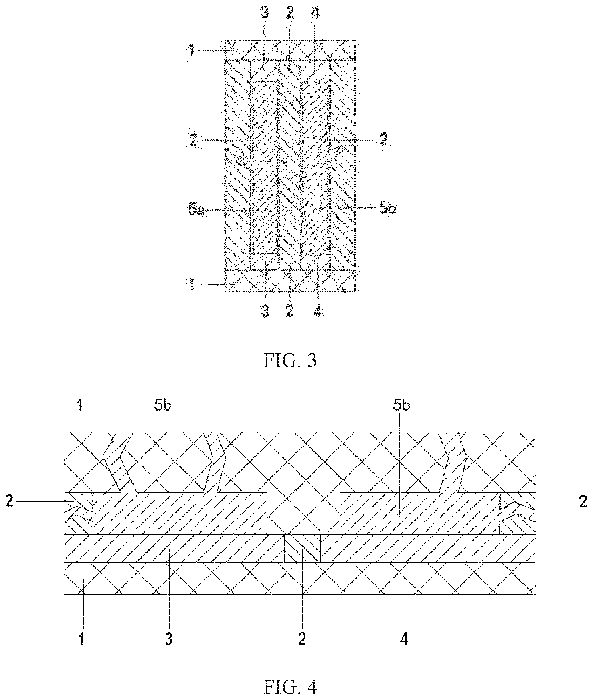

FIG. 1 and FIG. 2 may show an overcurrent protection structure that is when the conductive hot melt layer 5 is not melted. FIG. 3 and FIG. 4 show an overcurrent protection structure that is after the conductive hot melt layer 5 is overheated and fused. FIG. 3 is corresponding to the field of view in FIG. 1, and FIG. 4 is corresponding to the field of view in FIG. 2.

As shown in FIG. 3 and FIG. 4, when the semiconductor device is overheated due to overcurrent, the package body 1 cracks and forms a gap. The insulation layer 2 on the first conductive pad 3 and the second conductive pad 4 may also crack to form a gap. Shapes, quantities, and positions of the gaps in FIG. 3 and FIG. 4 are merely examples. Actually, distribution of the gaps is not limited thereto.

With reference to FIG. 3 and FIG. 1, and FIG. 4 and FIG. 2, when overcurrent occurs in the semiconductor device, heat of the chip in the semiconductor device is conducted to the conductive hot melt layer 5, so that the conductive hot melt layer 5 is melted. Due to a capillary effect of the gap and hydrophobicity of the insulation layer 2, the conductive hot melt layer 5 in the melt state is broken at the insulation layer 2 between the first conductive pad 3 and the second conductive pad 4, and flows into the gap. For example, the conductive hot melt layer 5 may be broken into a first part 5a and a second part 5b, and both the first part 5a and the second part 5b may enter corresponding gaps. In this way, an electrical connection between the first conductive pad 3 and the second conductive pad 4 is disconnected, so that the semiconductor device enters an open-circuit state. Therefore, the semiconductor device stops heating. This avoids burning the circuit board.

It can be learned according to the foregoing fuse principle of the conductive hot melt layer 5 that, because of the hydrophobicity of the insulation layer 2, it is difficult to keep the conductive hot melt layer 5 in the melt state on the insulation layer 2 staying on the insulation layer 2, and this helps the conductive hot melt layer 5 in the melt state on the insulation layer 2 enter a gap. Therefore, the hydrophobic performance of the insulation layer 2 causes the conductive hot melt layer 5 to fuse at the insulation layer 2. It may be understood that, if the insulation layer 2 does not have the hydrophobic performance, the conductive hot melt layer 5 may also be fused at the insulation layer 2 through proper design. In addition, the conductive hot melt layer 5 is fused by heat conducted by the chip, instead of being fused due to heat production of the conductive hot melt layer 5. This is different from a common fuse hot melt wire.

In embodiments of this application, when a quantity of conductive pads is greater than two, the conductive hot melt layer 5 may be broken at the insulation layer 2 between any two adjacent conductive pads near the gap. In this way, an open-circuit function can be implemented. The following describes a structure of the semiconductor device having the overcurrent protection structure and a semiconductor device manufacturing method.

### Embodiment 1: A semiconductor device that applies the overcurrent protection principle

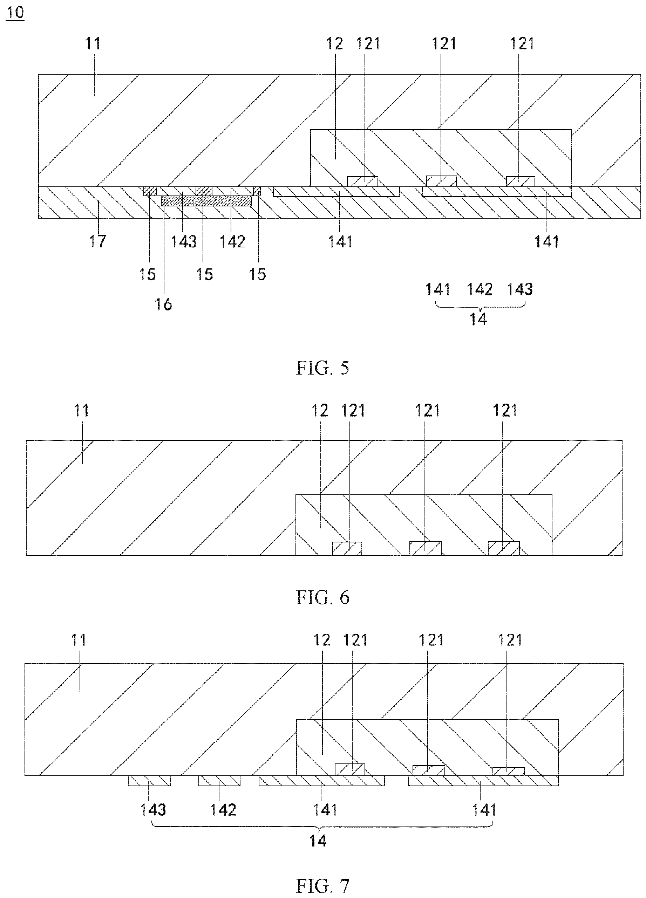

FIG. 5 schematically shows a structure of a semiconductor device 10 according to Embodiment 1. As shown in FIG. 5, the semiconductor device 10 may include a first package body 11, a chip 12, a redistribution layer 14, an insulation layer 15, a conductive hot melt layer 16, and a second package body 17. The first package body 11 and the second package body 17 are combined and jointly package the chip 12, the redistribution layer 14, the insulation layer 15, and the conductive hot melt layer 16. The chip 12 may be located in the first package body 11, and the redistribution layer 14, the insulation layer 15, and the conductive hot melt layer 16 may be located in the second package body 17. The first package body 11 and the second package body 17 may be made of a same material or different materials. A packaging manner of the semiconductor device 10 may be, for example, embedded component packaging. Specific descriptions are provided below.

As shown in FIG. 5, the chip 12 may be packaged in the first package body 11 by using a pre-packaging process, and pins 121 of the chip 12 may be exposed from the first package body 11, so as to be electrically connected to an external line. FIG. 5 shows three pins 121. It may be understood that, this is only an example. Actually, a quantity of pins 121 may be determined based on a requirement.

As shown in FIG. 5, the redistribution layer 14 may include a chip connection part 141, a first conductive pad 142, and a second conductive pad 143. The chip connection part 141, the first conductive pad 142, and the second conductive pad 143 are connected to form a path (in a side sectional view of FIG. 5, the chip connection part 141, the first conductive pad 142, and the second conductive pad 143 are disconnected at intervals, and actually, the three are connected). The chip connection part 141 may be connected to the pins 121, so as to electrically connect the chip 12 to the external line. Both the first conductive pad 142 and the second conductive pad 143 may be close to the chip 12, and spacings between the chip 12, and the first conductive pad 142 and the second conductive pad 143 may be determined as required. This is not limited in this embodiment. The first conductive pad 142 and the second conductive pad 143 are disposed at intervals. A gap between the first conductive pad 142 and the second conductive pad 143 may be small. For example, the gap may be between 0.1 mm and 5 mm.

As shown in FIG. 5, the insulation layer 15 may be formed between the first conductive pad 142 and the second conductive pad 143, to electrically isolate the first conductive pad 142 from the second conductive pad 143. For example, the insulation layer 15 may further be formed on a right side of the first conductive pad 142 and a left side of the second conductive pad 143. For example, there may be no insulation layer 15 on two sides of the conductive hot melt layer 16.

As shown in FIG. 5, the conductive hot melt layer 16 may be formed on a surface of the first conductive pad 142 and a surface of the second conductive pad 143, and a surface of the insulation layer 15 between the first conductive pad 142 and the second conductive pad 143. The conductive hot melt layer 16 is in electrical contact with both the first conductive pad 142 and the second conductive pad 143.

As shown in FIG. 5, the pins 121, the redistribution layer 14, and the conductive hot melt layer 16 of the chip 12 are electrically connected. When the semiconductor device 10 is powered on, the chip 12 may form a path with the external line by using the redistribution layer 14 and the conductive hot melt layer 16. It may be understood that the chip 12 may further have another pin, and the another pin may not be electrically connected to the redistribution layer 14 and the conductive hot melt layer 16.

When the semiconductor device 10 is overheated due to overcurrent, the conductive hot melt layer 16 can be heated and melted. According to the overcurrent protection mechanism described above, after the conductive hot melt layer 16 is melted, an open circuit occurs on the semiconductor device 10, so that the semiconductor device 10 stops heating. This avoids burning the circuit board.

### Embodiment 2: Manufacturing method of a semiconductor device 10

The manufacturing method in Embodiment 2 may include the following steps:
S101: Package a chip by using a first packaging material, where a pin of the chip is exposed.
S102: Form a redistribution layer on the first packaging material, where the redistribution layer includes a first conductive pad and a second conductive pad that are disposed at intervals and insulated, and a part of the redistribution layer other than the first conductive pad and the second conductive pad is connected to the pin of the chip.
S103: Form an insulation layer on the first packaging material, and enable the insulation layer to isolate the first conductive pad from the second conductive pad.
S104: Form a conductive hot melt layer on the first conductive pad, the insulation layer, and the second conductive pad, where the conductive hot melt layer is in electrical contact with both the first conductive pad and the second conductive pad.
S105: Package the redistribution layer, the insulation layer, and the conductive hot melt layer by using a second packaging material, where the second packaging material and the first packaging material are combined to jointly package the chip, the redistribution layer, the insulation layer, and the conductive hot melt layer.

The following describes the manufacturing method of the semiconductor device 10 with reference to FIG. 5 to FIG. 9.

As shown in FIG. 6, in step S101, the chip 12 may be packaged by using the first packaging material by using a pre-packaging process, so that a pin 121 of the chip 12 is exposed from the first packaging material. After step S101, the first packaging material may form a first package body 11. In step S101, the chip 12 may be preliminarily packaged to meet a specific product requirement.

As shown in FIG. 7, in step S102, the redistribution layer 14 may be formed on the first packaging material, that is, the redistribution layer 14 is formed on the formed first package body 11. The redistribution layer 14 may include a chip connection part 141, a first conductive pad 142, and a second conductive pad 143, so that the chip connection part 141 is connected to the pin 121 of the chip 12, and the first conductive pad 142 and the second conductive pad 143 are close to the chip 12. In other words, the first conductive pad 142 and the second conductive pad 143 may be formed together in a manufacturing process of the redistribution layer 14.

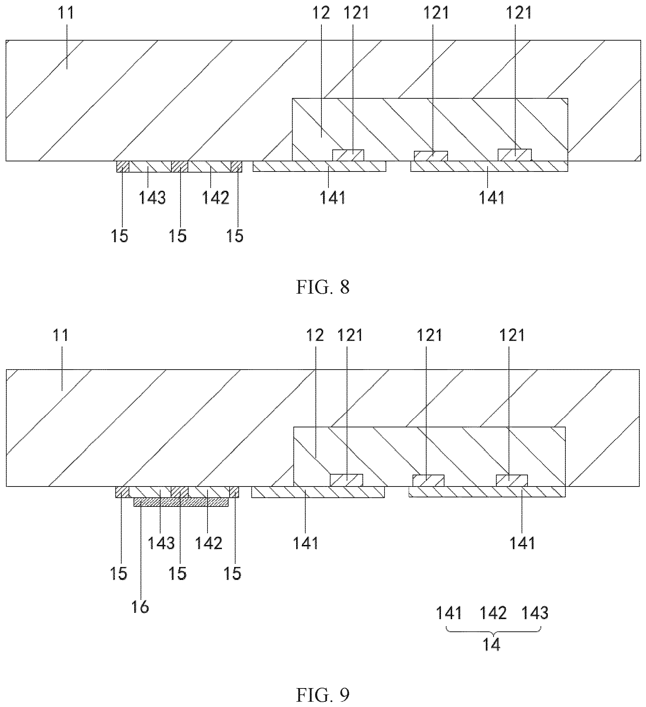

As shown in FIG. 8, in step S103, for example, the insulation layer 15 may be formed on the first package body 11 by using a solder mask defined (solder mask defined, SMD) or non-solder mask defined (non-solder mask defined, NSMD) design, and the insulation layer 15 isolates the first conductive pad 142 from the second conductive pad 143.

As shown in FIG. 9, in step S104, the conductive hot melt layer 16 is formed on a surface of the first conductive pad 142, a surface of the second conductive pad 143, and a surface of the insulation layer 15 between the first conductive pad 142 and the second conductive pad 143, so that the conductive hot melt layer 16 is in electrical contact with both the first conductive pad 142 and the second conductive pad 143. For example, the conductive hot melt layer 16 may be formed by using a printing process. Based on different specific materials of the conductive hot melt layer 16, the conductive hot melt layer 16 may be connected to an attachment surface of the conductive hot melt layer 16 by using an adhesive, or the adhesive may not be used.

As shown in FIG. 5, in step S105, the redistribution layer 14, the insulation layer 15, and the conductive hot melt layer 16 may be packaged by using the second package body material. The second package body material and the first package body material jointly package the chip 12, the redistribution layer 14, the insulation layer 15, and the conductive hot melt layer 16. After step S105, the second package body material may form a second package body 17. The second package body 17 and the first package body 11 are combined and jointly package the chip 12, the redistribution layer 14, the insulation layer 15, and the conductive hot melt layer 16.

The packaging process in Embodiment 2 may be, for example, embedded component packaging.

According to the manufacturing method in Embodiment 2, the first conductive pad 142 and the second conductive pad 143 are manufactured by using a manufacturing process of the redistribution layer 14, the insulation layer 15 is formed between the first conductive pad 142 and the second conductive pad 143, and the conductive hot melt layer 16 is formed on the first conductive pad 142 and the second conductive pad 143, so that an overcurrent protection structure can be manufactured by using a mature chip packaging process, so that design and manufacturing of the semiconductor device 10 are convenient, costs are low, and mass production is good.

### Embodiment 3: Another semiconductor device that applies the overcurrent protection principle

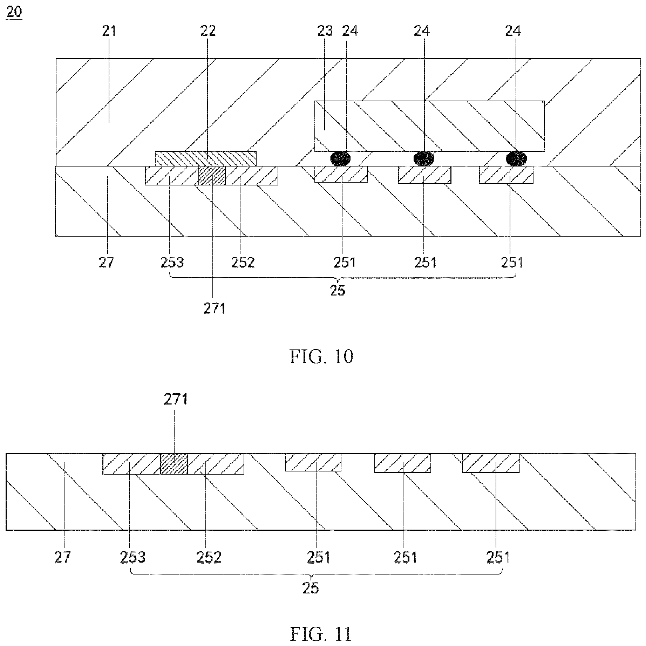

FIG. 10 schematically shows a structure of a semiconductor device 20 according to Embodiment 3. As shown in FIG. 10, the semiconductor device 20 may include a substrate 27, a redistribution layer 25, a chip 23, a conductive hot melt layer 22, and a package body 21. Details are described below.

As shown in FIG. 10, the redistribution layer 25 may be formed on the substrate 27. The substrate 27 has a local area 271, which is insulated, and may be, for example, manufactured by a polymer packaging material. A structure including the substrate 27 and the redistribution layer 25 may also be referred to as a substrate (substrate). The substrate 27 may further have another structure, which is not shown in FIG. 10 for brevity and highlight.

As shown in FIG. 10, the redistribution layer 25 may include a chip connection part 251, a first conductive pad 252, and a second conductive pad 253. The chip connection part 251, the first conductive pad 252, and the second conductive pad 253 are connected to form a path (in a side sectional view of FIG. 10, the chip connection part 251, the first conductive pad 252, and the second conductive pad 253 are disconnected at intervals, and actually, the three are connected). The chip connection part 251 is configured to connect to the chip 23, so as to electrically connect the chip 23 to an external line. Both the first conductive pad 252 and the second conductive pad 253 may be close to the chip 23, and spacings between the chip 23, and the first conductive pad 252 and the second conductive pad 253 may be determined as required. This is not limited in this embodiment. The first conductive pad 252 and the second conductive pad 253 are disposed at intervals. A gap between the first conductive pad 252 and the second conductive pad 253 may be small. For example, the gap may be between 0.1 mm and 5 mm.

As shown in FIG. 10, the local area 271 may be located between the first conductive pad 252 and the second conductive pad 253, to electrically isolate the first conductive pad 252 from the second conductive pad 253.

As shown in FIG. 10, the conductive hot melt layer 22 may be formed on a surface of the first conductive pad 252 and a surface of the second conductive pad 253, and a surface of the local area 271 between the first conductive pad 252 and the second conductive pad 253. The conductive hot melt layer 22 is in electrical contact with both the first conductive pad 252 and the second conductive pad 253.

As shown in FIG. 10, a pin of the chip 23 may be electrically connected to the chip connection part 251 by using an electrical connection material 24. The electrical connection material 24 may be, for example, solder paste. In this way, the chip 23, the redistribution layer 25, and the conductive hot melt layer 22 are electrically connected. When the semiconductor device 20 is powered on, the chip 23 may form a path with the external line by using the redistribution layer 25 and the conductive hot melt layer 22. It may be understood that the chip 23 may further have another pin, and the another pin may not be electrically connected to the redistribution layer 25 and the conductive hot melt layer 22.

As shown in FIG. 10, the package body 21 may cover the substrate 27, and package the redistribution layer 25, the chip 23, the conductive hot melt layer 22, and the like. A packaging manner of the semiconductor device 20 may be, for example, plastic packaging (molding).

When the semiconductor device 20 is overheated due to overcurrent, the conductive hot melt layer 22 can be heated and melted. According to the overcurrent protection mechanism described above, after the conductive hot melt layer 22 is melted, an open circuit occurs on the semiconductor device 20, so that the semiconductor device 20 stops heating. This avoids burning the circuit board.

### Embodiment 4: Manufacturing method of a semiconductor device 20

The manufacturing method in Embodiment 4 may include the following steps:
S201: Form a redistribution layer on a substrate, where the redistribution layer includes a first conductive pad and a second conductive pad that are disposed at intervals, and the first conductive pad and the second conductive pad are isolated by a local area of the substrate.
S202: Form a conductive hot melt layer on the first conductive pad, the local area, and the second conductive pad, so that the conductive hot melt layer is in electrical contact with both the first conductive pad and the second conductive pad.
S203: Connect a pin of the chip to a part of the redistribution layer other than the first conductive pad and the second conductive pad.
S204: Form a package body on the substrate, where the package body packages the chip, the redistribution layer, and the conductive hot melt layer.

The following describes the manufacturing method of the semiconductor device 20 with reference to FIG. 10 to FIG. 13.

As shown in FIG. 11, in step S201, for example, the redistribution layer 25 may be formed on the substrate 27 in a manufacturing process of the substrate. The redistribution layer 25 may include the chip connection part 251, the first conductive pad 252, and the second conductive pad 253. For example, the local area 271 may be formed by using a design such as an SMD or an NSMD, and the local area 271 isolates the first conductive pad 142 from the second conductive pad 143.

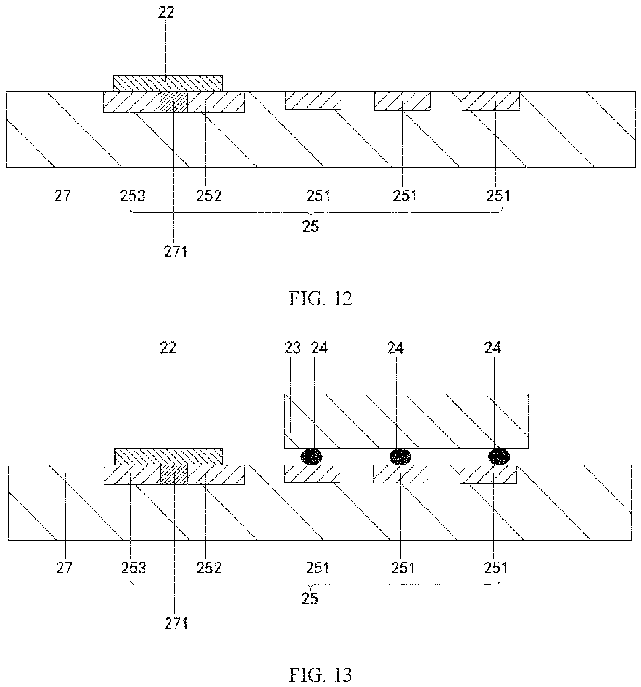

As shown in FIG. 12, in step S202, the conductive hot melt layer 22 may be formed on a surface of the first conductive pad 252, a surface of the second conductive pad 253, and a surface of the local area 271, so that the conductive hot melt layer 22 is in electrical contact with both the first conductive pad 252 and the second conductive pad 253. For example, the conductive hot melt layer 22 may be formed by using a printing process. Based on different specific materials of the conductive hot melt layer 22, the conductive hot melt layer 22 may be connected to an attachment surface of the conductive hot melt layer 22 by using an adhesive, or the adhesive may not be used.

As shown in FIG. 13, in step S203, for example, the pin of the chip 23 may be connected to the chip connection part 251 in the redistribution layer 25 by using an electrical connection material 24, where the electrical connection material 24 may be, for example, solder paste. The chip 23 may be disposed close to the conductive hot melt layer 22.

In Embodiment 4, a sequence of step S202 and step S203 may be determined based on a requirement, and is not limited to the foregoing description. For example, step S203 may be performed first to connect the chip 23 to the chip connection part 251, and then step S202 is performed to form the conductive hot melt layer 22.

As shown in FIG. 10, in step S204, a package body 21 may be formed on the substrate 27, so that the package body 21 packages the chip 23, the redistribution layer 25, and the conductive hot melt layer 22.

The packaging process in Embodiment 4 may be, for example, molding packaging.

According to the manufacturing method in Embodiment 4, the first conductive pad 142 and the second conductive pad 143 may be formed by using a manufacturing process of the substrate, and the conductive hot melt layer 16 may be formed on the first conductive pad 142 and the second conductive pad 143, so that an over-current protection structure can be manufactured by using a mature chip packaging process, so that design and manufacturing of the semiconductor device 20 are convenient, costs are low, and mass production is good.

It may be understood that core steps of the manufacturing method in embodiments of this application include: implanting the overcurrent protection structure into the packaging structure of the chip, manufacturing, by using the manufacturing process of the redistribution layer, the first conductive pad and the second conductive pad that are disposed at intervals and insulated, and forming the conductive hot melt layer on the surfaces of the first conductive pad and the second conductive pad. As for the step of connecting the redistribution layer to the pin of the chip, a sequence may be flexibly determined based on an actual requirement. For example, in the manufacturing method in Embodiment 2, the redistribution layer is first connected to the pin of the chip, and then the conductive hot melt layer is manufactured; and in the manufacturing method in Embodiment 4, the conductive hot melt layer may be first manufactured, and then the redistribution layer is connected to the pin of the chip.

A sequence of the steps of the manufacturing method in embodiments of this application may be adjusted, combined, or deleted based on an actual requirement. The sequence numbers of the foregoing steps do not mean execution sequences. The execution sequences of the steps should be determined based on functions and internal logic of the steps, and should not be construed as any limitation on the manufacturing method in embodiments of this application.

It should be further understood that first, second, and the like and various numerical symbols in this specification are merely used for differentiation for ease of description, and are not intended to limit the scope of this application. The term "and/or" in this specification describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A semiconductor device, comprising:
a package body, a chip, a redistribution layer, and a conductive hot melt layer, wherein
the chip, the redistribution layer, and the conductive hot melt layer are all packaged in the package body;
the redistribution layer comprises a first conductive pad and a second conductive pad that are disposed at intervals and insulated, wherein a part of the redistribution layer other than the first conductive pad and the second conductive pad is connected to a pin of the chip; and
the conductive hot melt layer is formed on a surface of the first conductive pad and a surface of the second conductive pad, and is in electrical contact with both the first conductive pad and the second conductive pad.

2. The semiconductor device according to claim 1, wherein
the semiconductor device comprises an insulation layer, wherein the insulation layer is located between the first conductive pad and the second conductive pad.

3. The semiconductor device according to claim 2, wherein
the insulation layer and the conductive hot melt layer further jointly cover the surface of the first conductive pad, and/or the insulation layer and the conductive hot melt layer further jointly cover the surface of the second conductive pad.

4. The semiconductor device according to claim 2 or 3, wherein
the insulation layer has hydrophobic performance.

5. The semiconductor device according to any one of claims 2 to 4, wherein
a material of the insulation layer comprises a solder resist material.

6. The semiconductor device according to any one of claims 1 to 5, wherein
the package body comprises a first package body and a second package body, wherein the first package body and the second package body are combined to jointly package the chip, the redistribution layer, and the conductive hot melt layer, the chip is packaged in the first package body, the pin is exposed outside the first package body, and both the redistribution layer and the conductive hot melt layer are packaged in the second package body.

7. The semiconductor device according to claim 1, wherein
the semiconductor device comprises a substrate;
the redistribution layer is formed on the substrate, and the first conductive pad and the second conductive pad are isolated by a local area of the substrate;
the chip is disposed on the substrate; and
the package body covers the substrate.

8. The semiconductor device according to any one of claims 1 to 7, wherein
a material of the conductive hot melt layer comprises solder.

9. The semiconductor device according to any one of claims 1 to 8, wherein
the semiconductor device comprises a power semiconductor device.

10. An electronic apparatus, comprising:
comprising a circuit board and the semiconductor device according to any one of claims 1 to 9, wherein the semiconductor device is disposed on the circuit board.

11. The electronic apparatus according to claim 10, wherein
the electronic apparatus comprises at least one of: a motor controller, a vehicle-mounted charger, a power supply, an inverter, an electric vehicle, a data center, a photovoltaic power generation device, and a server.

12. A semiconductor device manufacturing method, comprising:
forming a redistribution layer, wherein the redistribution layer comprises a first conductive pad and a second conductive pad that are disposed at intervals and insulated;
forming a conductive hot melt layer on the first conductive pad and the second conductive pad, wherein the conductive hot melt layer is in electrical contact with both the first conductive pad and the second conductive pad;
connecting a pin of a chip to a part of the redistribution layer other than the first conductive pad and the second conductive pad; and
packaging the chip, the redistribution layer, and the conductive hot melt layer by using a packaging material.

13. The manufacturing method according to claim 12, wherein
the "forming a redistribution layer, wherein the redistribution layer comprises a first conductive pad and a second conductive pad that are disposed at intervals and insulated" comprises:
packaging the chip by using a first packaging material, wherein the pin is exposed; and
forming the redistribution layer on the first packaging material, wherein the redistribution layer comprises the first conductive pad and the second conductive pad that are disposed at intervals;
forming an insulation layer between the first conductive pad and the second conductive pad, wherein the insulation layer isolates the first conductive pad from the second conductive pad; and
the "packaging the chip, the redistribution layer, and the conductive hot melt layer by using a packaging material" comprises:
packaging the redistribution layer, the insulation layer, and the conductive hot melt layer by using a second packaging material, wherein the second packaging material and the first packaging material are combined to jointly package the chip, the redistribution layer, the insulation layer, and the conductive hot melt layer.

14. The manufacturing method according to claim 12, wherein
the "forming a redistribution layer, wherein the redistribution layer comprises a first conductive pad and a second conductive pad that are disposed at intervals and insulated" comprises:
forming the redistribution layer on a substrate, wherein the redistribution layer comprises the first conductive pad and the second conductive pad that are disposed at intervals, and the first conductive pad and the second conductive pad are isolated by a local area of the substrate; and
the "packaging the chip, the redistribution layer, and the conductive hot melt layer by using a packaging material" comprises:
forming a package body on the substrate, wherein the package body packages the chip, the redistribution layer, and the conductive hot melt layer.
